# EUROPEAN PATENT APPLICATION

(11) **EP 4 319 513 A1**
(43) Date of publication of application: **07.02.2024**
(21) Application number: 22794243.0
(22) Date of filing: 29.01.2022
(51) Int. Cl.: H05K 3/46, H05K 3/42, H05K 1/11

(54) **CIRCUIT BOARD STRUCTURE AND MANUFACTURING METHOD THEREFOR**

(30) Priority: 29.04.2021 CN 202110476577
(71) Applicant: Chengdu T-Ray Technology Co., Ltd., Chengdu, Sichuan 610015 (CN); Southeast University, Nanjing, Jiangsu 211189 (CN)
(72) Inventor: XU, Hao, Chengdu, Sichuan 610015 (CN); ZHAO, Dixian, Chengdu, Sichuan 610015 (CN); YOU, Xiaohu, Chengdu, Sichuan 610015 (CN); CHEN, Zhihui, Chengdu, Sichuan 610015 (CN)
(74) Representative: Caspary, Karsten
(86) International application number: PCT/CN2022/074990
(87) International publication number: WO 2022/227762

(57) **Abstract**

Provided in the present application are a circuit board structure and a manufacturing method therefor, relating to the technical field of integrated circuits. The present application comprises stacking a plurality of circuit boards to be stacked, and using an adhesive medium capable of use in a normal-temperature low-voltage environment between each two adjacent circuit boards to be stacked for bonding to form a corresponding multi-layer circuit board body, in order to avoid the impact of a high-temperature high-voltage environment on the properties of the material, and effectively expand the number of layers of stackable circuit boards and the buildable structural thickness of the circuit board structure. The present application then comprises forming on the board surface of the multi-layer circuit board body at least one through hole penetrating through the multi-layer circuit board body and, for each through hole, using silver paste of matching viscosity to fill the through hole to form a conduction hole corresponding to the through hole, thus, by means of the silver paste filling process, solving the problem that the bonding medium is unable to sink copper and ensuring that the plurality of circuit boards to be stacked included in the circuit board structure can conduct effectively.

## Description

### FIELD OF THE DISCLOSURE

The present disclosure relates to the field of integrated circuits, and in particular, to a circuit board structure and a manufacturing method thereof.

### BACKGROUND OF THE DISCLOSURE

The manufacturing process of a conventional multi-layer circuit board structure includes alternately laminating multiple single-layer circuit boards and multiple prepregs according to a designed sequence of lamination, pressing them together in a high-temperature and high-pressure environment in cooperation with a traditional press, and then processing through holes that penetrate all single-layer circuit boards by means of electroless copper plating to form corresponding via holes to connect the multiple single-layer circuit boards to each other. It should be noted that such a manufacturing process will lead to material performance failure in case of too many times of press, due to the fact that the materials themselves typically have heat-resistant and pressure-resistant limits, and will cause failure to effectively convert through holes with a too large depth into via holes due to the limited throw power of an agent used for electroless copper plating, so that the number of circuit board layers and the thickness of the prepared multi-layer circuit board structure are obviously not large.

### SUMMARY OF THE DISCLOSURE

In view of the above, it is an object of the present disclosure to provide a circuit board structure and a manufacturing method thereof, which are capable of effectively enlarging the number of laminatable circuit board layers and constructable structural thickness of the circuit board structure, and ensuring that a plurality of to-be-laminated circuit boards comprised in the circuit board structure are effectively conductive.

I In order to achieve the object above, the technical solutions employed in the embodiments of the present disclosure are as follows.

According to a first aspect, the present disclosure provides a method for manufacturing a circuit board structure, the method comprising:
Providing a plurality of to-be-laminated circuit boards;
Stacking the plurality of to-be-laminated circuit boards, and performing bonding between two adjacent to-be-laminated circuit boards with an adhesive medium to form a multi-layer circuit board body;
Boring a side surface of the multilayer circuit board body to form at least one through hole penetrating the multilayer circuit board body;
Filling each through hole with a viscosity-matched silver paste to form a via hole corresponding to the through hole.

In an optional implementation, if the multilayer circuit board body comprises at least one interconnection circuit board arrangement disposed between a top layer circuit board and a bottom layer circuit board, each interconnection circuit board arrangement comprising at least two to-be-laminated circuit boards stacked consecutively, the method further comprises the following:
Ina process for forming each interconnection circuit board arrangement included in the multilayer circuit board body, boring each of the to-be-laminated circuit boards included in the interconnection circuit board arrangement respectively to form a first through hole at a same location of each of the to-be-laminated circuit boards included in the interconnection circuit board arrangement;
Stacking the individual to-be-laminated circuit boards included in the interconnection circuit board arrangement on top of each other, and bonding adjacent to-be-laminated circuit boards in the interconnection circuit board arrangement with an adhesive medium so that projected positions of the first through holes in the individual to-be-laminated circuit boards included in the interconnection circuit board arrangement overlap;
Filling the plurality of first through holes having an overlapping projected position in the interconnection circuit board arrangement with a viscosity-matched silver paste, to form a buried via hole corresponding to the plurality of first through holes, wherein the buried via hole is used to intercommunicate the individual to-be-laminated circuit boards included in the interconnection circuit board arrangement.

In an optional implementation, if the multilayer circuit board body comprises at least one first intercommunication circuit board arrangement independent of a top layer circuit board, each first intercommunication circuit board arrangement comprising a bottom layer circuit board and at least one to-be-laminated circuit board stacked with the bottom layer circuit board, the method further comprises:
In a process for forming each first intercommunication circuit board arrangement included in the multilayer circuit board body, stacking the individual to-be-laminated circuit boards included in the first intercommunication circuit board arrangement on top of each other, and bonding adjacent to-be-laminated circuit boards in the first intercommunication circuit board arrangement with an adhesive medium, to obtain a to-be-treated circuit board arrangement;
Boring a side surface of the to-be-treated circuit board arrangement to form at least one second through hole penetrating the to-be-treated circuit board arrangement;
Filling each second through hole with a viscosity-matched silver paste, to form a first blind via hole corresponding to the second through hole in the first intercommunication circuit board arrangement, wherein the first blind via hole is used to intercommunicate the individual to-be-laminated circuit boards included in the first intercommunication circuit board arrangement.

In an optional implementation, if the multilayer circuit board body comprises at least one second intercommunication circuit board arrangement independent of a bottom layer circuit board, each second intercommunication circuit board arrangement comprising a top layer circuit board and at least one to-be-laminated circuit board stacked with the top layer circuit board, the method further comprises:
In a process for forming each second intercommunication circuit board arrangement included in the multilayer circuit board body, boring each of the to-be-laminated circuit boards included in the second intercommunication circuit board arrangement respectively to form a third through hole at a same location of each of the to-be-laminated circuit boards included in the second intercommunication circuit board arrangement;
Stacking the individual to-be-laminated circuit boards included in the second intercommunication circuit board arrangement on top of each other, and bonding adjacent to-be-laminated circuit boards in the second intercommunication circuit board arrangement with an adhesive medium so that projected positions of the third through holes in the individual to-be-laminated circuit boards included in the second intercommunication circuit board arrangement overlap;
Filling the plurality of third through holes having an overlapping projected position in the second intercommunication circuit board arrangement with a viscosity-matched silver paste, to form a second blind via hole corresponding to the plurality of third through holes, wherein the second blind via hole is used to intercommunicate the individual to-be-laminated circuit boards included in the second intercommunication circuit board arrangement.

In an optional implementation, for a through hole with an aspect ratio greater than 15, a correspondingly matched silver paste viscosity is smaller than 2.5P;
For a through hole with an aspect ratio greater than 8 and not more than 15, a correspondingly matched silver paste viscosity is between 2.5P and 3.5P;
For a through hole with an aspect ratio of smaller than or equal to 8, a correspondingly matched silver paste viscosity is between 3.5P and 5.5P.

According to a second aspect, the present disclosure provides a circuit board structure, the structure comprising a multilayer circuit board body, wherein the multilayer circuit board body is formed by stacking and bonding a plurality of to-be-laminated circuit boards to each other;
At least one through hole penetrating the multilayer circuit board body is provided in a board surface of the multilayer circuit board body, and each through hole is filled with a viscosity-matched silver paste to form a corresponding via hole.

In an optional implementation, the multilayer circuit board body comprises a top layer circuit board, a bottom layer circuit board, and at least one interconnection circuit board arrangement disposed between the top layer circuit board and the bottom layer circuit board, each interconnection circuit board arrangement comprising at least two to-be-laminated circuit boards stacked consecutively;
The plurality of to-be-laminated circuit boards included in each interconnection circuit board arrangement are each provided with a first through hole having an overlapping projected position, and the plurality of first through holes corresponding to the interconnection circuit board arrangement are filled with a viscosity-matched silver paste to form a buried via hole for the interconnection circuit board arrangement.

In an optional implementation, the multilayer circuit board body comprises at least one first intercommunication circuit board arrangement independent of a top layer circuit board, and each first intercommunication circuit board arrangement comprises a bottom layer circuit board and at least one to-be-laminated circuit board stacked with the bottom layer circuit board;
At least one second through hole penetrating the first intercommunication circuit board arrangement is provided in a board surface of each first intercommunication circuit board arrangement, and each second through hole is filled with a viscosity-matched silver paste to form a first blind via hole for the first intercommunication circuit board arrangement.

In an optional implementation, the multilayer circuit board body comprises at least one second intercommunication circuit board arrangement independent of a bottom layer circuit board, each second intercommunication circuit board arrangement comprising a top layer circuit board and at least one to-be-laminated circuit board stacked with the top layer circuit board;
The plurality of to-be-laminated circuit boards included in each second intercommunication circuit board arrangement are each provided with a third through hole having an overlapping projected position, and the plurality of third through holes corresponding to the second intercommunication circuit board arrangement are filled with a viscosity-matched silver paste so as to form a second blind via hole for the second intercommunication circuit board arrangement.

In an optional implementation, for a through hole with an aspect ratio greater than 15, a correspondingly matched silver paste viscosity is smaller than 2.5P;
For a through hole with an aspect ratio greater than 8 and not more than 15, a correspondingly matched silver paste viscosity is between 2.5P and 3.5P;
For a through hole with an aspect ratio of smaller than or equal to 8, a correspondingly matched silver paste viscosity is between 3.5P and 5.5P.

In this context, the beneficial effects of the embodiments of the present disclosure include the following.

The present disclosure forms a corresponding multilayer circuit board body by stacking a plurality of to-be-laminated circuit boards and bonding two adjacent to-be-laminated circuit boards with an adhesive medium that can be used in a room-temperature and low-pressure environment, so as to avoid the effects of a high-temperature and high-pressure environment on material properties, and to effectively enlarge the number of laminatable circuit board layers and constructable structural thickness of the circuit board structure. Afterwards, at least one through hole penetrating the multi-layer circuit board body is formed in a board surface of the multi-layer circuit board body, and each through hole is subjected to hole filling with a viscosity-matched silver paste to form a via hole corresponding to the through hole, so that the adhesive medium's failure of electroless copper plating can be solved through a silver paste filling process, and effective conduction of the plurality of to-be-laminated circuit boards included in the circuit board structure can be ensured.

In order to make the above objects, features and advantages of the present disclosure more apparent, preferred embodiments are exemplified below, and are described in detail as follows in conjunction with the accompanying drawings.

### BRIEF DESCRIPTION OF THE DRAWINGS

In order to more clearly illustrate the technical solutions of the embodiments of the present disclosure, the accompanying drawings to be used in the embodiments will be briefly introduced below. It should be understood that the following figures are only illustrative of certain embodiments of the present disclosure, and therefore should not be regarded as limiting to its scope. For those skilled in the art, other related drawings could also be obtained from these drawings without exercise of any ingenuity.
FIG. 1 is a first schematic flowchart of a method for manufacturing a circuit board structure according to an embodiment of the present disclosure;
FIG. 2 is a schematic cross-sectional view of a circuit board structure manufactured on the basis of the manufacturing method shown in FIG. 1;
FIG. 3 is a second schematic flowchart of a method for manufacturing a circuit board structure according to an embodiment of the present disclosure;
FIG. 4 is a schematic cross-sectional view of a circuit board structure manufactured on the basis of the manufacturing method shown in FIG. 3;
FIG. 5 is a third schematic flowchart of a method for manufacturing a circuit board structure according to an embodiment of the present disclosure;
FIG. 6 is a schematic cross-sectional view of a circuit board structure manufactured on the basis of the manufacturing method shown in FIG. 5;
FIG. 7 is a fourth schematic flowchart of a method for manufacturing a circuit board structure according to an embodiment of the present disclosure;
FIG. 8 is a schematic cross-sectional view of a circuit board structure manufactured on the basis of the manufacturing method shown in FIG. 7; and
FIG. 9 is a schematic cross-sectional view of a circuit board structure manufactured on the basis of the manufacturing methods shown in FIGS. 1, 3, 5, and 7.

Reference numbers in the figures include: 100 - circuit board structure; 110 - to-be-laminated circuit board; 120 - multilayer circuit board body; 130 - through hole; 140 - via hole; 111 - top layer circuit board; 112 - bottom layer circuit board; 113 - interconnection circuit board arrangement; 114 - first through hole; 150 - buried via hole; 115 - first intercommunication circuit board arrangement; 116 - second through hole; 160 - first blind via hole; 117-second intercommunication circuit board arrangement; 118-third through hole; 170-second blind via hole.

### DETAILED IMPLEMENTATION OF THE DISCLOSURE

In order to make the objects, technical solutions and advantages of the embodiments of the present disclosure clearer, the technical solutions in the embodiments of the present disclosure will be clearly and completely described below in conjunction with the accompanying drawings. Apparently, the embodiments described herein are some, but not all, embodiments of the present disclosure. The components in the embodiments of the present disclosure described and illustrated herein may generally be arranged and designed in a variety of different configurations.

Accordingly, the following detailed description of the embodiments of the present disclosure as provided in the accompanying drawings is not intended to limit the scope of the present disclosure, but merely to indicate selected embodiments of the present disclosure. Based on the embodiments in the present disclosure, all other embodiments obtained without exercise of ingenuity by a person of ordinary skill in the art fall within the scope of protection of the present disclosure.

It should be noted that like reference numerals and letters refer to like items in the following figures, and thus, once an item is defined in one figure, it need not be further defined and explained in subsequent ones.

In the description of the present disclosure, it should be noted that an orientation or a positional relationship indicated by such terms as "upper", "lower", "inner" and "outer", if any, is based on that shown in the drawings, or that of the product of the present disclosure as it is in use. This is only for ease and simplicity of description, without indicating or implying that the device or the element referred to must have a specific orientation, or be constructed and operated in a particular orientation, and thus it should not be construed as limiting to the present disclosure.

It is to be noted that relational terms such as "first" and "second" herein are used only to distinguish one entity or operation from another, and do not necessarily require or imply any such actual relationship or order between those entities or operations. Furthermore, the terms "including", "comprising", or any other variant thereof, are intended to cover non-exclusive inclusion, such that a process, method, article, or apparatus comprising a set of elements includes not only those elements, but also other elements not expressly listed, or elements that are inherent to such process, method, article or apparatus. Without further limitation, the fact that an element is defined by the phrase "comprising a ......" does not preclude the existence of additional identical elements in the process, method, article or apparatus that comprises the element. For a person of ordinary skill in the art, the specific meanings of these terms in the present disclosure may be understood in specific contexts.

Some embodiments of the present disclosure are described in detail below in conjunction with the accompanying drawings. The following embodiments and features therein may be combined with each other in the absence of conflicts.

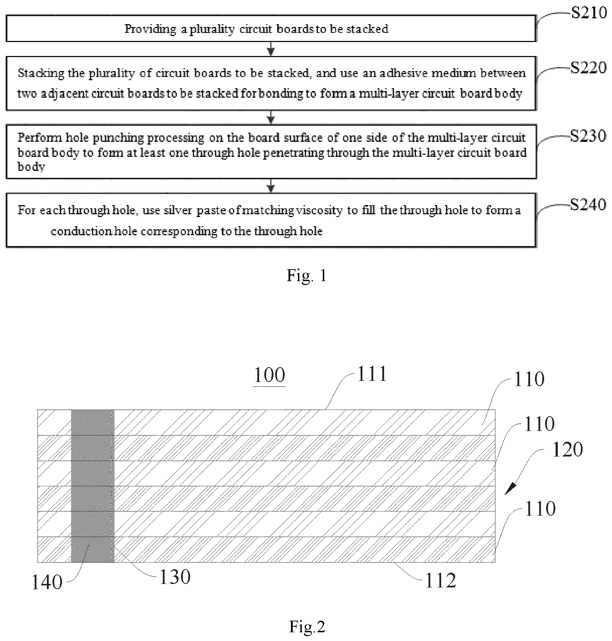

Referring to FIGS. 1 and 2 in combination, FIG. 1 is a first schematic flowchart of a method for manufacturing a circuit board structure according to an embodiment of the present disclosure, and FIG. 2 is a schematic cross-sectional view of a circuit board structure 100 manufactured on the basis of the manufacturing method shown in FIG. 1. In the embodiment of the present disclosure, the method for manufacturing a circuit board structure shown in FIG. 1 can effectively enlarge the number of laminatable circuit board layers and constructable structural thickness of the circuit board structure 100, and ensure that a plurality of to-be-laminated circuit boards 110 comprised in the circuit board structure 100 are efficiently conductive. The specific processes and steps of the method for manufacturing a circuit board structure shown in FIG. 1 are detailed as below.

At step S210, a plurality of to-be-laminated circuit boards are provided.

In this embodiment, the to-be-laminated circuit boards 110 may be single-layer circuit boards, or multilayer circuit boards that have been prepared, wherein the single-layer circuit boards may be, but are not limited to, any of common epoxy circuit boards, flexible circuit boards, ceramic circuit boards, etc., and the multilayer circuit boards may be formed by using any one or a combination of common epoxy circuit boards, flexible circuit boards, ceramic circuit boards, etc. In addition, the respective board surface sizes of the plurality of the to-be-laminated circuit boards 110 provided may be identical or completely different, and it is also possible that some of the to-be-laminated circuit boards 110 have a same board surface size.

At step S220, a plurality of to-be-laminated circuit boards are stacked, and an adhesive medium is used between two adjacent to-be-laminated circuit boards for bonding, so as to form a multilayer circuit board body.

In this embodiment, the plurality of to-be-laminated circuit boards 110 included in the multilayer circuit board body 120 are stacked on top of each other in a particular stacking order, and each to-be-laminated circuit board 110 is bonded to other adjacent to-be-laminated circuit boards 110by means of an adhesive medium. The adhesive medium typically has the characteristics of low fluidity, high bonding strength, bond ability at room temperature and normal pressure, and capability of withstanding high temperatures of reflow soldering after bonding, which can ensure that the lamination operations among the plurality of to-be-laminated circuit boards 110 is free from the influence of a high temperature and high pressure environment on the material properties, thereby enlarging the number of laminatable circuit board layers and constructable structural thickness of the circuit board structure 100. The adhesive medium may be, but is not limited to, an epoxy resin-based liquid adhesive, an acrylic resin-based liquid adhesive, a polyimide-based liquid adhesive, and a solid adhesive tape.

In one implementation of this embodiment, ifa solid adhesive tape is used as the adhesive medium, when bonding two to-be-laminated circuit boards 110 that are stacked up, a size-matched adhesive tape is die-cut in advance in accordance with the surface size of the to-be-laminated circuit boards 110, and then, in coordination with pins and a dedicated fixture for alignment of the adhesive tape, the adhesive tape with oneside of the release film removed is affixed on one side surface of oneto-be-laminated circuit board 110; then the release film on the other side of the adhesive tape is peeled off, and also with pins and a dedicated fixture for alignment, the other to-be-laminated circuit board 110 is stacked on and bonded to the previous to-be-laminated circuit board 110 through the adhesive tape. Thereafter, a rolling apparatus is used to ensure that the two to-be-laminated circuit boards 110 are bonded completely. In this process, in order to avoid the generation of bubbles and/or dust mixing, the bonding operation of the circuit boards needs to be performed in a dust-free vacuum environment.

At step S230, a boring process is performed on a side board surface of the multilayer circuit board body to form at least one through hole penetrating the multilayer circuit board body.

In this embodiment, after the multilayer circuit board body 120 is formed by performing the step S220, the multilayer circuit board body 120 may directly comprise a top layer circuit board 111, a bottom layer circuit board 112, and at least one to-be-laminated circuit board 110 located between the top layer circuit board 111 and the bottom layer circuit board 112. At this point, boring may be performed on a board surface of the top layer circuit board 111 away from the bottom layer circuit board 112, or on a board surface of the bottom layer circuit board 112 away from the top layer circuit board 111, thereby forming at least one through hole 130 in the multilayer circuit board body 120 that penetrates the multilayer circuit board body 120.

At step S240, for each through hole, a viscosity-matched silver paste is used to perform a hole filling process on the through hole, to form a via hole corresponding to the through hole.

In this embodiment, after a through hole 130 is constructed, the multilayer circuit board body 120 can be fixed together with a hole filling fixture after removal of the adhesive residue in the hole, and then a viscosity-matched silver paste is selected according to an aspect ratio corresponding to the through hole 130 for hole filling from one side surface of the multilayer circuit board body 120, so as to fill the through hole 130 with the silver paste. Afterwards, upon complete standing, baking and curing is carried out to form a corresponding via hole 140. The aspect ratio of the through hole 130 is a ratio between the thickness of the corresponding multilayer circuit board body 120 and the diameter of the through hole 130. The present disclosure may, with reference to such principles that "a correspondingly matched silver paste viscosity is between 3.5P and 5.5P for an aspect ratio smaller than or equal to 8, between 2.5P and 3.5P for an aspect ratio greater than 8 and not more than 15, and smaller than 2.5P for an aspect ratio greater than 15", select a silver paste viscosity that matches the throughhole 130 to implement silver paste filling, so that the adhesive medium's failure of electroless copper plating can be solved through a silver paste filling process, and effective conduction of the plurality of to-be-laminated circuit boards 110 included in the circuit board structure 100 can be ensured.

In one implementation of the present embodiment, in order to prevent the existence of voids in the silver paste in the hole, the silver paste needs to be stirred sufficiently before filling, and the silver paste filling process is carried out in a vacuum environment.

As a result, the present disclosure can, through the execution of the above step S220, avoid the effects of a high-temperature and high-pressure environment on material properties, and effectively enlarge the number of laminatable circuit board layers and constructable structural thickness of the circuit board structure 100; and by executing the above step S240, the present disclosure solves the adhesive medium's failure of electroless copper plating through a silver paste filling process, thus achieving the effective plating of a high-aspect-ratio via hole and ensuring effective conduction of the plurality of to-be-laminated circuit boards 110 included in the circuit board structure 100.

In the present disclosure, if the engineer has needs for a buried via hole in the circuit board structure 100 to be constructed, it is necessary that the number of to-be-laminated circuit boards 110 between the corresponding top layer circuit board 111 and the bottom layer circuit board 112 be designed to be multiple, and a buried via hole structure satisfying the buried via hole requirements be constructed in the foregoing forming process of the multi-layer circuit board body. To this end, the present disclosure may also provide a circuit board structure manufacturing method for constructing a buried via hole structure during the forming process of a multilayer circuit board body. The specific processes and steps of this circuit board structure manufacturing method are described in detail as below.

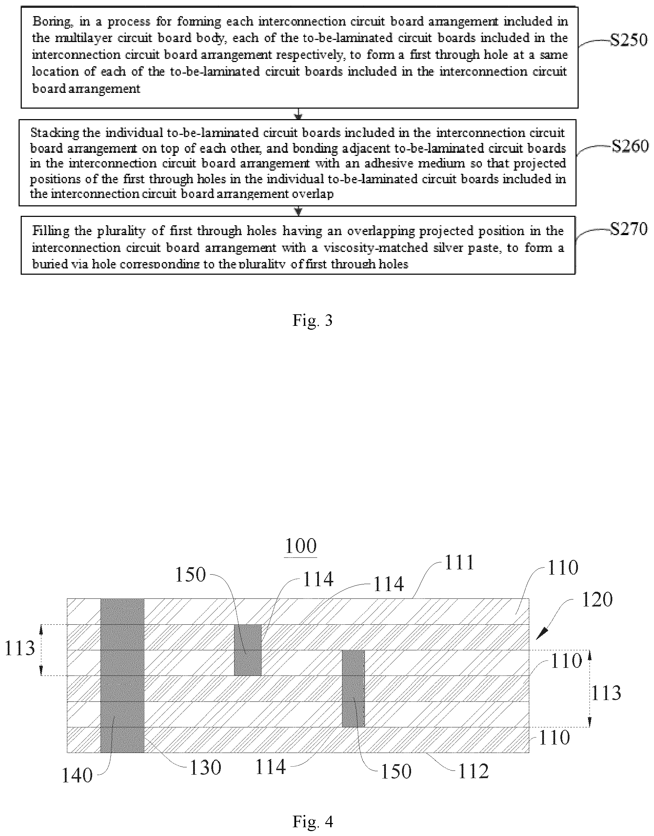

Referring to FIGS. 3 and 4 in combination, FIG. 3 is a second schematic flowchart of a method for manufacturing a circuit board structure according to an embodiment of the present disclosure, and FIG. 4 is a schematic cross-sectional view of a circuit board structure 100 manufactured on the basis of the manufacturing method shown in FIG. 3. In this embodiment of the present disclosure, the circuit board structure manufacturing method shown in FIG. 3 is used to construct a buried via hole 150 on the basis of the circuit board structure 100 shown in FIG. 2, and the circuit board structure manufacturing method shown in FIG. 3 is applied in the specific execution of step S220 shown in FIG. 1.

In the circuit board structure 100 manufactured based on the manufacturing method shown in FIG. 3, the plurality of to-be-laminated circuit boards 110that are stacked, located between the top layer circuit board 111 and the bottom layer circuit board 112 and included in the multilayer circuit board body 120 in the circuit board structure 100 may correspondingly be divided into at least one interconnection circuit board arrangement 113, each interconnection circuit board arrangement 113 including at least two to-be-laminated circuit boards 110 stacked consecutively, and a same to-be-laminated circuit board 110 may be divided into different interconnection circuit board arrangements 113 (e.g., the third to-be-laminated circuit board 110 in FIG. 4 is divided into two interconnection circuit board arrangements 113 at the same time). And then, a matching buried via hole 150 is constructed for each interconnection circuit board arrangement 113 based on the circuit board structure manufacturing method shown in FIG. 3. In this case, the circuit board structure manufacturing method shown in FIG. 3 may include steps S250 to S270.

At step S250, during the forming process of each interconnection circuit board arrangement included in the multilayer circuit board body, a boring process is performed respectively on each to-be-laminated circuit board included in the interconnection circuit board arrangement to form a first through hole at a same location of each to-be-laminated circuit board included in the interconnection circuit board arrangement.

In this embodiment, when an interconnection circuit board arrangement 113 needs to be constructed and formed during the construction of the multilayer circuit board body 120, a boring process needs to be preferentially performed at a same board surface position of each to-be-laminated circuit board 110 included in the interconnection circuit board arrangement 113 respectively, so as to provide a first through hole 114 in each to-be-laminated circuit board 110 included in the interconnection circuit board arrangement 113. The respective projected positions of the first through holes 114 in all of the to-be-laminated circuit boards 110 included in a same interconnection circuit board arrangement 113 overlap, such that when all of the to-be-laminated circuit boards 110 included in the interconnection circuit board arrangement 113 are stacked on top of each other, the plurality of the first through holes 114 with an overlapping projected position may be regarded as one through hole penetrating the interconnection circuit board arrangement 113.

In one implementation of this embodiment, each to-be-laminated circuit board 110 included in a same interconnection circuit board arrangement 113 has first through holes 114 formed at a plurality of board surface locations respectively, so as to form a plurality of through holes penetrating the interconnection circuit board arrangement 113 as the interconnection circuit board arrangement 113 is formed.

At step S260, the individual to-be-laminated circuit boards included in the interconnection circuit board arrangement are stacked on top of each other, and an adhesive medium is used to bond adjacent to-be-laminated circuit boards in the interconnection circuit board arrangement, so that the projected positions of the first through holes in the individual to-be-laminated circuit boards included in the interconnection circuit board arrangement overlap.

In this embodiment, after corresponding first through holes 114 are constructed ineach of the to-be-laminated circuit boards 110 included in a same interconnection circuit board arrangement 113, the individual to-be-laminated circuit boards 110 included in the same interconnection circuit board arrangement 113 may be stacked on top of each other with direct reference to step S220, and an adhesive medium may be used to bond adjacent to-be-laminated circuit boards 110 in the interconnection circuit board arrangement 113, so that the projected positions of the first through holes 114 in the individual to-be-laminated circuit boards 110 included in the interconnection circuit board arrangement 113 overlap.

At step S270, a plurality of first through holes with an overlapping projected position in the interconnection circuit board arrangement are filled with a viscosity-matched silver paste to form a buried via hole corresponding to the plurality of first through holes.

In this embodiment, upon completion of the bonding operation of the interconnection circuit board arrangement 113, the plurality of first through holes 114 of the interconnection circuit board arrangement 113 that have an overlapping projected position may be directly regarded as one through hole all through the interconnection circuit board arrangement 113. Then a matching silver paste viscosity is selected according to the aspect ratio of the through hole running through the interconnection circuit board arrangement 113 to perform a silver paste filling process on the plurality of first through holes 114 with an overlapping projected position, thereby forming a buried via hole 150 corresponding to the interconnection circuit board arrangement 113, so as to intercommunicate the individual to-be-laminated circuit boards 110 included in the interconnection circuit board arrangement 113 through the buried via hole 150. The aspect ratio corresponding to the plurality of first through holes 114 with an overlapping projected position may be expressed as a ratio between the thickness of the board body of a corresponding interconnection circuit board arrangement 113 and the diameter of the first through holes 114.

As a result, the present disclosure may ensure that the finally prepared circuit board structure 100 has buried via holes 150 that meet the engineer's buried via requirements by executing the above steps S250 to S270 during the execution of the above step S220, and at the same time, it can also ensure that the prepared buried via holes 150 are able to effectively conduct the plurality of intermediate to-be-laminated circuit boards 110 included in the circuit board structure 100.

In the present disclosure, if the engineer has needs for a blind via hole in the circuit board structure 100 to be constructed, it is necessary that the number of to-be-laminated circuit boards 110 between the corresponding top layer circuit board 111 and the bottom layer circuit board 112 be designed to be multiple, and a blind via hole structure satisfying the blind via requirements be constructed in the foregoing forming process of the multi-layer circuit board body. To this end, the present disclosure may also provide a circuit board structure manufacturing method for constructing a blind via hole structure during the forming process of a multilayer circuit board body. The specific processes and steps of this circuit board structure manufacturing method are described in detail as below.

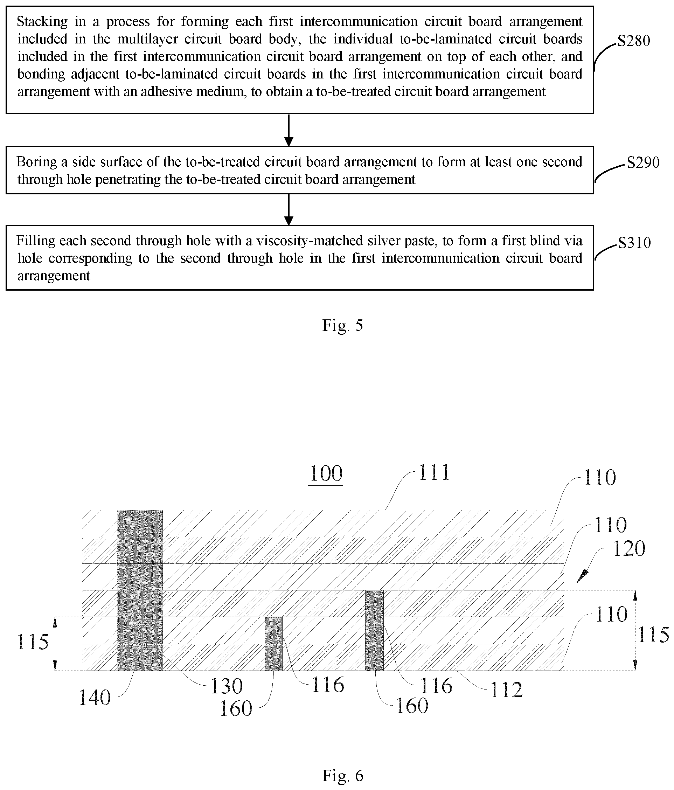

Optionally, referring to FIGS. 5 and 6 in combination, FIG. 5 is a third schematic flowchart of a method for manufacturing a circuit board structure according to an embodiment of the present disclosure, and FIG. 6 is a schematic cross-sectional view of a circuit board structure manufactured on the basis of the manufacturing method shown in FIG. 5. In this embodiment of the present disclosure, the circuit board structure manufacturing method shown in FIG. 5 is used to construct a first blind hole 160 corresponding to the bottom layer circuit board 112 on the basis of the circuit board structure 100 shown in FIG. 2, and the circuit board structure manufacturing method shown in FIG. 5 is applied in the specific execution of step S220 shown in FIG. 1.

In the circuit board structure 100 manufactured on the basis of the manufacturing method shown in FIG. 5, the other to-be-laminated circuit boards 110 than the top layer circuit board 111 that are included in the multilayer circuit board body 120 in the circuit board structure 100may correspondingly be divided into at least one first intercommunication circuit board arrangement 115, such that each first intercommunication circuit board arrangement 115 includes a bottom layer circuit board 112 and at least one to-be-laminated circuit board 110 stacked to the bottom layer circuit board 112. A same to-be-laminated circuit board 110 may be divided into different first intercommunication circuit board arrangements 115 (e.g., the fifth to-be-laminated circuit board 110 in FIG. 6 is divided into two first intercommunication circuit board arrangements 115 at the same time). Subsequently, a matching first blind hole 160 is constructed for each of the first intercommunication circuit board arrangements 115 based on the circuit board manufacturing method shown in FIG. 5. At this point, the circuit board manufacturing method shown in FIG. 5 may include steps S280, S290, and S310.

At step S280, in a process for forming each first intercommunication circuit board arrangement 115 included in the multilayer circuit board body 120, the individual to-be-laminated circuit boards 110 included in the first intercommunication circuit board arrangement 115 are stacked on top of each other, and adjacent to-be-laminated circuit boards in the first intercommunication circuit board arrangement are bonded with an adhesive medium, so as to obtain a to-be-treated circuit board arrangement.

In this embodiment, when it is necessary to construct and form a first interconnecting circuit board arrangement 115 during the construction of a multilayer circuit board body 120, reference may directly be made to step S220, whereby the individual to-be-laminated circuit boards 110 included in the first interconnecting circuit board arrangement 115 are stacked on top of each other, and adjacent to-be-laminated circuit boards 110 in the first intercommunication circuit board arrangement 115 are bonded with an adhesive medium, so as to obtain a to-be-treated circuit board arrangement.

At step S290, boring is performed on a side surface of the to-be-treated circuit board arrangement to form at least one second through hole penetrating the to-be-treated circuit board arrangement.

In this embodiment, upon completing the bonding operation of the first intercommunication circuit board arrangement 115 (i.e., obtaining the to-be-treated circuit board arrangement), at least one second through hole 116 penetrating the to-be-treated circuit board arrangement may be formed by boring a board surface of the to-be-treated circuit board arrangement corresponding to the first intercommunication circuit board arrangement 115 with reference to the above-stated step S230, where the aspect ratio of the second through hole 116 is a ratio between a board body thickness of the first intercommunication circuit board arrangement 115 and a dimeter of the second through hole 116.

At step S310, for each second through hole, a viscosity-matched silver paste is used to perform a hole filling process on the second through hole, to form a first blind via hole corresponding to the second through hole in the first intercommunication circuit board arrangement.

In this embodiment, after at least one second through hole 116 is formed in the to-be-treated circuit board arrangement corresponding to the first intercommunication circuit board arrangement 115, a matching silver paste viscosity may be selected according to the aspect ratio of the second through hole 116 to perform a silver paste filling process on each second through hole116, thereby forming a blind via hole 160 for the first intercommunication circuit board arrangement 115, so as to intercommunicate the individual to-be-laminated circuit boards 110 included in the first intercommunication circuit board arrangement 115 through the first blind via hole 160.

As a result, the present disclosure may ensure that the finally prepared circuit board structure 100 has a first blind via hole 160 that meets the engineer's blind via requirements by executing the above steps S280 to S310 during the execution of the above step S220, and at the same time, it can also ensure that the prepared blind via hole 160 is able to effectively conduct the plurality of to-be-laminated circuit boards 110 at the bottom that are included in the circuit board structure 100.

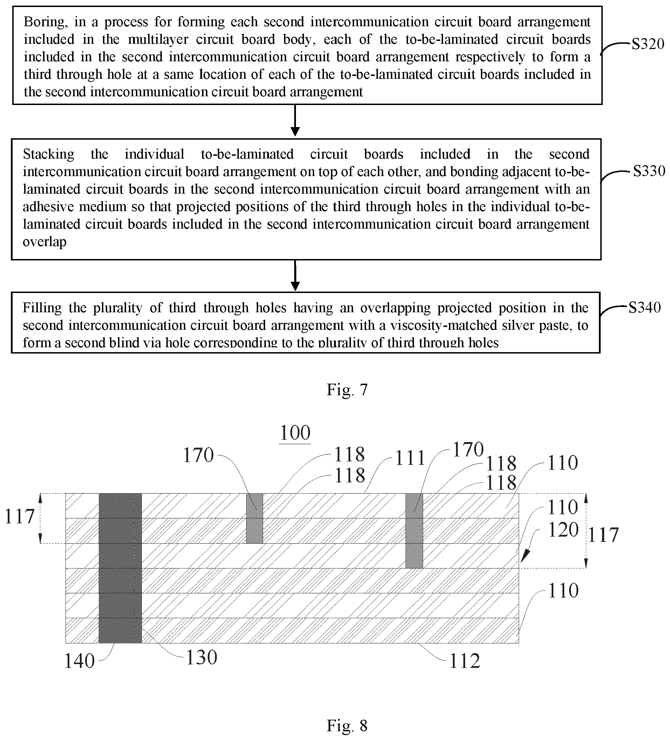

Optionally, referring to FIGS. 7 and 8 in combination, FIG. 7 is a fourth schematic flowchart of a method for manufacturing a circuit board structure according to an embodiment of the present disclosure, and FIG. 8 is a schematic cross-sectional view of a circuit board structure 100 manufactured on the basis of the manufacturing method shown in FIG. 7. In this embodiment of the present disclosure, the circuit board structure manufacturing method shown in FIG. 7 is used to construct a second blind via hole 170 corresponding to the top layer circuit board 111 on the basis of the circuit board structure 100 shown in FIG. 2, and the circuit board structure manufacturing method shown in FIG. 7 is applied in the specific execution of the step S220 shown in FIG. 1.

In the circuit board structure 100 manufactured on the basis of the manufacturing method shown in FIG. 7, the other to-be-laminated circuit boards 110 than the bottom layer circuit board 112 that are included in the multilayer circuit board body 120 in the circuit board structure 100 may correspondingly be divided into at least one second intercommunication circuit board arrangement 117, such that each second intercommunication circuit board arrangement 117 includes a top layer circuit board 111 and at least one to-be-laminated circuit board 110 stacked to the top layer circuit board 111. A same to-be-laminated circuit board 110 may be divided into different second intercommunication circuit board arrangements 117 (e.g., the second to-be-laminated circuit board 110 in FIG. 8 is divided into two second intercommunication circuit board arrangements 117 at the same time). Subsequently, a matching second blind via hole 170 is constructed for each of the second intercommunication circuit board arrangements 117 based on the circuit board manufacturing method shown in FIG. 7. In this context, the circuit board manufacturing method shown in FIG. 7 may include steps S320 to S340.

At step S320, in a process for forming each second intercommunication circuit board arrangement included in the multilayer circuit board body, a boring process is performed respectively on each of to-be-laminated circuit boards included in the second intercommunication circuit board arrangement, so as to form a third through hole at a same location of each of the to-be-laminated circuit boards included in the second intercommunication circuit board arrangement.

In this embodiment, when a second intercommunication circuit board arrangement 117 needs to be constructed and formed during the construction of the multilayer circuit board body 120, a boring process needs to be preferentially performed at a same board surface position of each to-be-laminated circuit board 110 included in the second intercommunication circuit board arrangement 117 respectively, so as to provide a third through hole 118 in each to-be-laminated circuit board 110 included in the second intercommunication circuit board arrangement 117. The respective projected positions of the third through holes 118 in all of the to-be-laminated circuit boards 110 included in a second intercommunication circuit board arrangement 117 overlap, such that when all of the to-be-laminated circuit boards 110 included in the second intercommunication circuit board arrangement 117 are stacked on top of each other, the plurality of the third through holes 118 with an overlapping projected position may be regarded as one through hole penetrating the second intercommunication circuit board arrangement 117.

In one implementation of this embodiment, each to-be-laminated circuit board 110 included in a same second intercommunication circuit board arrangement 117 has third through holes 118 formed at a plurality of board surface locations respectively, so as to form a plurality of through holes penetrating the second intercommunication circuit board arrangement 117 as the second intercommunication circuit board arrangement 117 is formed.

At step S330, the individual to-be-laminated circuit boards included in the second intercommunication circuit board arrangement are stacked on top of each other, and an adhesive medium is used to bond adjacent to-be-laminated circuit boards in the second intercommunication circuit board arrangement, so that the projected positions of the third through holes in the individual to-be-laminated circuit boards included in the second intercommunication circuit board arrangement overlap.

In this embodiment, after corresponding third through holes 118 are constructed in each of the to-be-laminated circuit boards 110 included in a second intercommunication circuit board arrangement 117, the individual to-be-laminated circuit boards 110 included in a same second intercommunication circuit board arrangement 117 may be stacked on top of each other with direct reference to step S220, and an adhesive medium may be used to bond adjacent to-be-laminated circuit boards 110 in the second intercommunication circuit board arrangement 117, so that the projected positions of the third through holes 118 in the individual to-be-laminated circuit boards 110 included in the second intercommunication circuit board arrangement 117 overlap.

At step S340, a plurality of third through holes with an overlapping projected position in the second intercommunication circuit board arrangement are filled with a viscosity-matched silver paste to form a second blind via hole corresponding to the plurality of third through holes.

In this embodiment, upon completion of the bonding operation of the second intercommunication circuit board arrangement 117, the plurality of third through holes 118 of the second intercommunication circuit board arrangement 117 that have an overlapping projected position may be directly regarded as one through hole all through the second intercommunication circuit board arrangement 117. Then a matching silver paste viscosity is selected according to the aspect ratio of the through hole running through the second intercommunication circuit board arrangement 117 to perform a silver paste filling process on the plurality of third through holes 118 with an overlapping projected position, thereby forming a second blind via hole 170 corresponding to the second intercommunication circuit board arrangement 117 so as to intercommunicate the individual to-be-laminated circuit boards 110 included in the second intercommunication circuit board arrangement 117 through the second blind via hole 170. The aspect ratio corresponding to the plurality of third through holes 118 with an overlapping projected position may be expressed as a ratio between the thickness of the board body of a corresponding second intercommunication circuit board arrangement 117 and the diameter of the third through holes 118.

As a result, the present disclosure may ensure that the finally prepared circuit board structure 100 has blind via holes 170 that meet the engineer's blind via requirements by executing the above steps S250 to S270 during the execution of the above step S220, and at the same time, it can also ensure that the prepared blind via holes 170 are able to effectively conduct the plurality of to-be-laminated circuit boards 110 at the top that are included in the circuit board structure 100.

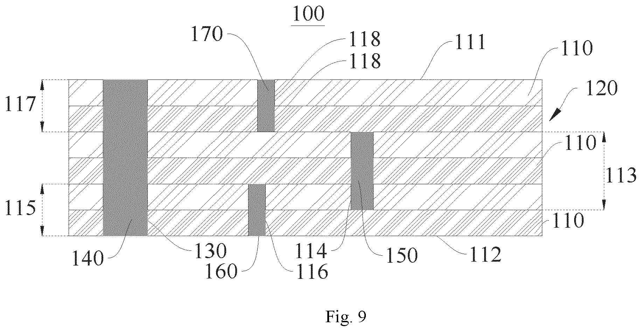

It is to be understood that any one or a combination of the circuit board structure manufacturing methods shown in FIGS. 3, 5, and 7 provided in the present disclosure may be selected by an engineer according to his or her own needs during the execution of the circuit board structure manufacturing method shown in FIG. 1, so as to ensure that the finally prepared circuit board structure 100 is able to efficiently enlarge the number of laminatable circuit board layers and constructable structural thickness and that a plurality of to-be-laminated circuit boards 110 comprised in the circuit board structure 100 are efficiently conductive while correspondingly meeting the engineer's needs for buried/blind via holes. For example, the circuit board structure 100 shown in FIG. 9 is a device structure prepared by simultaneously adopting the circuit board structure manufacturing methods illustrated in FIGS. 1, 3, 5, and 7, and the fifth to-be-laminated circuit board 110 in FIG. 9 may serve as both a part of the interconnection circuit board arrangement 113 and a part of the first intercommunication circuit board arrangement 115.

In summary, in a circuit board structure and a manufacturing method thereof provided by embodiments of the present disclosure, a corresponding multilayer circuit board body is formed by stacking a plurality of to-be-laminated circuit boards and bonding two adjacent to-be-laminated circuit boards with an adhesive medium that can be used in a room-temperature and low-pressure environment, so as to avoid the effects of a high-temperature and high-pressure environment on material properties, and to effectively enlarge the number of laminatable circuit board layers and constructable structural thickness of the circuit board structure. Afterwards, at least one through hole penetrating the multi-layer circuit board body is formed in a board surface of the multi-layer circuit board body, and each through hole is subjected to hole filling with a viscosity-matched silver paste to form a via hole corresponding to the through hole, so that the adhesive medium's failure of electroless copper plating can be solved through a silver paste filling process, and effective conduction of the plurality of to-be-laminated circuit boards included in the circuit board structure can be ensured.

The above are merely various embodiments of the present disclosure, but the scope of protection of the present disclosure is not limited thereto. Any variations or substitutions within the technical scope disclosed herein that could readily be conceived by a person skilled in the art should fall within the scope of the present disclosure. Therefore, the scope of protection of the present disclosure shall be subject to the protection scope of the appending claims.

## Claims

1. A method for manufacturing a circuit board structure, comprising:
providing a plurality of to-be-laminated circuit boards;
stacking the plurality of to-be-laminated circuit boards, and performing bonding between two adjacent to-be-laminated circuit boards with an adhesive medium to form a multi-layer circuit board body;
boring a side surface of the multilayer circuit board body to form at least one through hole penetrating the multilayer circuit board body; and
filling each through hole with a viscosity-matched silver paste to form a via hole corresponding to the through hole.

2. The method according to claim 1, wherein if the multilayer circuit board body comprises at least one interconnection circuit board arrangement disposed between a top layer circuit board and a bottom layer circuit board, each interconnection circuit board arrangement comprising at least two to-be-laminated circuit boards stacked consecutively, the method further comprises:
in a process for forming each interconnection circuit board arrangement included in the multilayer circuit board body, boring each of the to-be-laminated circuit boards included in the interconnection circuit board arrangement respectively, to form a first through hole at a same location of each of the to-be-laminated circuit boards included in the interconnection circuit board arrangement;
stacking the individual to-be-laminated circuit boards included in the interconnection circuit board arrangement on top of each other, and bonding adjacent to-be-laminated circuit boards in the interconnection circuit board arrangement with an adhesive medium so that projected positions of the first through holes in the individual to-be-laminated circuit boards included in the interconnection circuit board arrangement overlap; and
filling the plurality of first through holes having an overlapping projected position in the interconnection circuit board arrangement with a viscosity-matched silver paste, to form a buried via hole corresponding to the plurality of first through holes, wherein the buried via hole is used to intercommunicate the individual to-be-laminated circuit boards included in the interconnection circuit board arrangement.

3. The method according to claim 1, wherein if the multilayer circuit board body comprises at least one first intercommunication circuit board arrangement independent of a top layer circuit board, each first intercommunication circuit board arrangement comprising a bottom layer circuit board and at least one to-be-laminated circuit board stacked with the bottom layer circuit board, the method further comprises:
in a process for forming each first intercommunication circuit board arrangement included in the multilayer circuit board body, stacking the individual to-be-laminated circuit boards included in the first intercommunication circuit board arrangement on top of each other, and bonding adjacent to-be-laminated circuit boards in the first intercommunication circuit board arrangement with an adhesive medium, to obtain a to-be-treated circuit board arrangement;
boring a side surface of the to-be-treated circuit board arrangement to form at least one second through hole penetrating the to-be-treated circuit board arrangement; and
filling each second through hole with a viscosity-matched silver paste, to form a first blind via hole corresponding to the second through hole in the first intercommunication circuit board arrangement, wherein the first blind via hole is used to intercommunicate the individual to-be-laminated circuit boards included in the first intercommunication circuit board arrangement.

4. The method according to claim 1, wherein if the multilayer circuit board body comprises at least one second intercommunication circuit board arrangement independent of a bottom layer circuit board, each second intercommunication circuit board arrangement comprising a top layer circuit board and at least one to-be-laminated circuit board stacked with the top layer circuit board, the method further comprises:
in a process for forming each second intercommunication circuit board arrangement included in the multilayer circuit board body, boring each of the to-be-laminated circuit boards included in the second intercommunication circuit board arrangement respectively to form a third through hole at a same location of each of the to-be-laminated circuit boards included in the second intercommunication circuit board arrangement;
stacking the individual to-be-laminated circuit boards included in the second intercommunication circuit board arrangement on top of each other, and bonding adjacent to-be-laminated circuit boards in the second intercommunication circuit board arrangement with an adhesive medium so that projected positions of the third through holes in the individual to-be-laminated circuit boards included in the second intercommunication circuit board arrangement overlap; and
filling the plurality of third through holes having an overlapping projected position in the second intercommunication circuit board arrangement with a viscosity-matched silver paste, to form a second blind via hole corresponding to the plurality of third through holes, wherein the second blind via hole is used to intercommunicate the individual to-be-laminated circuit boards included in the second intercommunication circuit board arrangement.

5. The method according to any one of claims 1-4, wherein for a through hole with an aspect ratio greater than 15, a correspondingly matched silver paste viscosity is smaller than 2.5P, wherein for a through hole with an aspect ratio greater than 8 and not more than 15, a correspondingly matched silver paste viscosity is between 2.5P and 3.5P, and wherein for a through hole with an aspect ratio of smaller than or equal to 8, a correspondingly matched silver paste viscosity is between 3.5P and 5.5P.

6. A circuit board structure, comprising a multilayer circuit board body, the multilayer circuit board body being formed by stacking and bonding a plurality of to-be-laminated circuit boards to each other, wherein at least one through hole penetrating the multilayer circuit board body is provided in a board surface of the multilayer circuit board body, and wherein each through hole is filled with a viscosity-matched silver paste to form a corresponding via hole.

7. The structure according to claim 6, wherein the multilayer circuit board body comprises a top layer circuit board, a bottom layer circuit board, and at least one interconnection circuit board arrangement disposed between the top layer circuit board and the bottom layer circuit board, each interconnection circuit board arrangement comprising at least two to-be-laminated circuit boards stacked consecutively,
wherein the plurality of to-be-laminated circuit boards included in each interconnection circuit board arrangement are each provided with a first through hole having an overlapping projected position, and wherein the plurality of first through holes corresponding to the interconnection circuit board arrangement are filled with a viscosity-matched silver paste to form a buried via hole for the interconnection circuit board arrangement.

8. The structure according to claim 6, wherein the multilayer circuit board body comprises at least one first intercommunication circuit board arrangement independent of a top layer circuit board, each first intercommunication circuit board arrangement comprising a bottom layer circuit board and at least one to-be-laminated circuit board stacked with the bottom layer circuit board,
wherein at least one second through hole penetrating the first intercommunication circuit board arrangement is provided in a board surface of each first intercommunication circuit board arrangement, and wherein each second through hole is filled with a viscosity-matched silver paste to form a first blind via hole for the first intercommunication circuit board arrangement.

9. The structure according to claim 6, wherein the multilayer circuit board body comprises at least one second intercommunication circuit board arrangement independent of a bottom layer circuit board, each second intercommunication circuit board arrangement comprising a top layer circuit board and at least one to-be-laminated circuit board stacked with the top layer circuit board,
wherein the plurality of to-be-laminated circuit boards included in each second intercommunication circuit board arrangement are each provided with a third through hole having an overlapping projected position, and wherein the plurality of third through holes corresponding to the second intercommunication circuit board arrangement are filled with a viscosity-matched silver paste so as to form a second blind via hole for the second intercommunication circuit board arrangement.

10. The structure according to any one of claims 6-9, wherein for a through hole with an aspect ratio greater than 15, a correspondingly matched silver paste viscosity is smaller than 2.5P, wherein for a through hole with an aspect ratio greater than 8 and not more than 15, a correspondingly matched silver paste viscosity is between 2.5P and 3.5P, and wherein for a through hole with an aspect ratio of smaller than or equal to 8, a correspondingly matched silver paste viscosity is between 3.5P and 5.5P.
